# EUROPÄISCHE PATENTSCHRIFT

(11) **EP 2 157 206 B1**
(45) Veröffentlichungstag und Bekanntmachung des Hinweises auf die Patenterteilung: **06.03.2019**
(21) Anmeldenummer: 09009166.1
(22) Anmeldetag: 14.07.2009
(51) Int. Cl.: C23C 16/455, C23C 16/448, C23C 16/04

(54) **Versorgungsvorrichtung**
Supply device
Dispositif d'alimentation

(30) Priorität: 08.08.2008 DE 102008037160
(43) Veröffentlichungstag der Anmeldung: 24.02.2010
(73) Patentinhaber: Krones AG, 93073 Neutraubling (DE)
(72) Erfinder: Humele, Heinz, 93073 Neutraubling (DE); Kursawe, Andreas, 93073 Neutraubling (DE); Kraus, Andreas, 93073 Neutraubling (DE); Krüger, Jochen, Dr., 93073 Neutraubling (DE); Felts, John, 93073 Neutraubling (DE)
(74) Vertreter: Grünecker Patent- und Rechtsanwälte PartG mbB

(56) Entgegenhaltungen:
- EP-A- 0 361 171
- WO-A-93/24243
- WO-A1-03/100125
- JP-A- 11 323 558
- US-A- 5 308 649

## Beschreibung

Die Erfindung bezieht sich auf eine Beschichtungs vorrichtung zum Versorgen einer Vielzahl von Abnehmerstationen mit einer vorbestimmten Menge eines Prozessmediums, der im Oberbegriff von Anspruch 1 erläuterten Art.

Eine derartige Vorrichtung ist aus der US 2005/0233077 bekannt. Die bekannte Vorrichtung dient zur Innenbeschichtung von Behältern, insbesondere Flaschen für eine Getränkeabfüllung. Die Vorrichtung ist in einen Rundläufer integriert, der die Behälter über eine Prozessstrecke führt, deren Länge auf die notwendige Behandlungszeit, hier Beschichtungszeit, abgestimmt ist. Das Prozessmedium bzw. die Prozessmedien, die für eine Behandlung des Behälters notwendig sind, werden über Ventile zugeführt. Dabei ist für jede Abnehmerstation und jedes Prozessmedium jeweils ein Ventil notwendig. Um die Anzahl der Ventile zu reduzieren wird in dieser Druckschrift bereits vorgeschlagen, in jeder Abnehmerstation zwei Behälter an den Anschluss für ein Prozessmedium anzuschließen, so dass sich die Anzahl der notwendigen Ventile halbiert. Trotzdem sind noch eine Vielzahl Ventile notwendig, die die Anlage sehr teuer machen.

Es ist bereits bekannt, beispielsweise aus der JP-A-11323558 oder der EP-A-361 171 oder der US-A-5,308,649 oder der WO93/24243, Kapillare in Beschichtungsvorrichtungen einzusetzen. Dort dienen sie jedoch bisher nur dazu, Beschichtungsmittel auf kontrollierte und definierte Weise zu verdampfen.

Der Erfindung liegt die Aufgabe zugrunde, eine konstruktiv einfache, preisgünstige Vorrichtung zum Versorgen einer Vielzahl von Abnehmerstationen mit einer vorbestimmten Menge eines Prozessmediums zu schaffen.

Die Aufgabe wird durch die im Anspruch 1 angegebenen Merkmale gelöst.

Durch die erfindungsgemäße Ausgestaltung werden Ventile ggf. vollständig unnötig bzw. es ist lediglich ein einziges Prozessmedium-Ventil notwendig. Auf diese Weise wird die erfindungsgemäße Vorrichtung konstruktiv stark vereinfacht und die Kosten für ihre Herstellung stark reduziert.

Definierte Strömungsverhältnisse wirden weiterhin dadurch aufrechterhalten, dass die Kapillarstrecke mit einer Druckkammer verbunden wird, die als Puffer wirkt.

Wenn der Druckunterschied selbstregulierend konstant gehalten wird, wird die Vorrichtung weiter vereinfacht.

Durch die erfindungsgemäße Ausgestaltung können alle Abnehmerstationen mit Prozessmedium versorgt werden, wobei lediglich für jede Abnehmerstation und jedes Prozessmedium eine Kapillarstrecke vorgesehen werden muss.

Vorteilhafte Weiterbildungen der Erfindung sind den Unteransprüchen zu entnehmen.

Die Ausgestaltung der Kapillarstrecke als Kunststoffrohr vereinfacht die Herstellung zusätzlich, da Kunststoffrohre auf einfache Weise in die entsprechenden Abmessungen gebracht werden können.

Um definierte Strömungsverhältnisse aufrechtzuerhalten, sollte die Temperatur des Prozessmediums, das durch die Kapillarstrecke fließt, in reproduzierbarer Weise konstant gehalten werden, was bevorzugt durch einen Wärmespeicher geschieht, in dem die Kapillarstrecke untergebracht ist. Zusätzlich kann eine Heizeinrichtung vorgesehen sein.

Ein weiterer, sehr entscheidender Vorteil der Verwendung einer Kapillarstrecke liegt darin, dass bei flüssig vorliegenden Prozessmedien, die jedoch gasförmig benötigt werden, die Kapillarstrecke an ihrer Ausmündung in das Vakuum als Verdampfereinrichtung fungiert, die ein als Flüssigkeit dosiertes Prozessmedium ohne gesonderte Vorkehrungen in den gasförmigen Zustand überführt.

Ein Ausführungsbeispiel der Erfindung wird nachfolgend anhand der Zeichnungen näher erläutert. Es zeigen:
- Fig. 1: einen Querschnitt durch eine erfindungsgemäße Vorrichtung in stark schematisierter Darstellung,
- Fig. 2: eine Abnehmerstation in geschlossenem Zustand, und
- Fig. 3: eine Abnehmerstation zum Einführen von Prozessmedium.

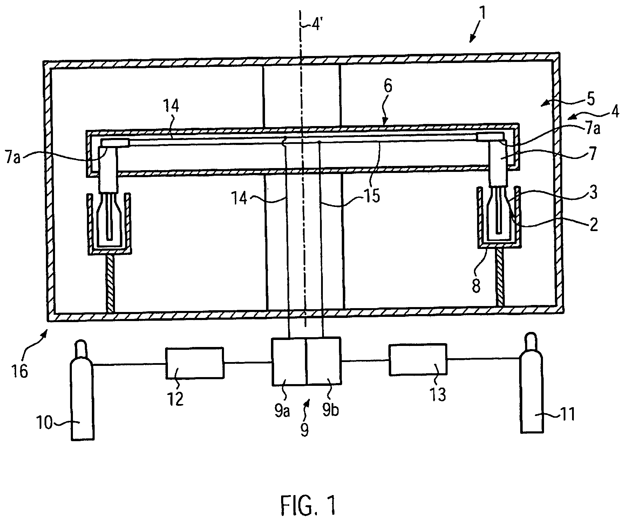

Fig. 1 zeigt in stark schematisierter Darstellung eine Vorrichtung 1 zum Versorgen einer Vielzahl von Abnehmerstationen 2 mit einer vorbestimmten Menge eines Prozessmediums. Die Vorrichtung 1 ist im dargestellten Ausführungsbeispiel als Plasmabeschichtungsanlage ausgebildet, die dazu dient, in der Abnehmerstation 2 angeordnete Behälter 3, dargestellt sind Kunststoffflaschen, mit einer Beschichtung zu versehen, die die Gasdichtheit, die UV-Beständigkeit[JK2], die UV-Abschirmwirkung oder dergleichen der Behälter verbessert. Diese Beschichtung wird im dargestellten Ausführungsbeispiel auf die Innenseite der Behälter 3 aufgebracht.

Die Vorrichtung 1 enthält einen Rundläufer 4, d.h. eine Vorrichtung, die die Behälter 3 um eine Achse 4' von einer Aufnahmestation (nicht gezeigt) zu einer Abgabestation (nicht gezeigt) über eine dazwischenliegende Behandlungsstrecke fördert. Der Rundläufer 4 enthält eine erste Druckkammer 5, die die Außenseite des Behälters 3 beaufschlagt, und eine zweite Druckkammer 6, die mit der Innenseite des Behälters 3 in Verbindung steht und in der ersten Druckkammer 5 angeordnet ist. Die Druckkammern 5 und 6 werden auf unterschiedlichen Drücken gehalten, und sind beide als Vakuumkammern ausgebildet. Für eine Innenbeschichtung wird die zweite Druckkammer 6 auf einem Druck gehalten, bei dem ein Plasma leicht zünden kann (gewöhnlich <1mbar), während in der Druckkammer 5 ein höherer oder niedriger Druck herrscht, bei dem das Plasma nicht zünden kann.

An jeder Abnehmerstation 2 ist jeweils ein Gasdruck-Ventil 7 vorgesehen. Jede Abnehmerstation 2 enthält weiterhin eine Halterung für die Behälter 3, durch die die Behälter 3 mit ihrer Öffnung gegen das Ventil 7 gedrückt werden können. Diese Bewegung zum Verschließen der Öffnung des Behälters 3 durch das Ventil 7 erfolgt bevorzugt über eine Hubkurve oder dergleichen, die den Behälter 3 anhebt und gegen das darüber liegende Ventil andrückt. Jede Abnehmerstation 2 enthält weiterhin eine Elektrode 8, die beispielsweise Ringform haben oder U-förmig sein kann.

Obwohl im dargestellten Ausführungsbeispiel nur zwei Abnehmerstationen 2 gezeigt sind, ist klar, dass um die Achse 4' verteilt eine Vielzahl von Abnehmerstationen 2 vorgesehen sein können. Auch kann jede Abnehmerstation 2 mehr als einen Behälter 3 aufnehmen.

Das für eine Plasmabeschichtung erforderliche Prozessmedium bzw. die erforderlichen Prozessmedien gelangen über eine Drehdurchführung 9 in den Rundläufer 4, bevorzugt im Bereich der Drehachse 4'. Die Drehdurchführung 9 wird von einer oder mehreren Vorratsquellen 10, 11 versorgt. Im dargestellten Ausführungsbeispiel ist dies für eine Beschichtung mit Siliziumoxid ein erster Vorratsbehälter 10 für ein gasförmiges Prozessmedium, insbesondere Sauerstoff, und ein zweiter Vorratsbehälter 11 für ein flüssiges Prozessmedium, beispielsweise ein flüssiges Monomer, wie z.B. Hexamethyldisiloxan (HMDSO) oder ein anderes Silan.

Jeder dieser Vorratsbehälter 10, 11 ist jeweils über ein Ventil 12, 13 mit einer dritten Druckkammer 9a bzw. vierten Druckkammer 9b in der Drehdurchführung 9 verbunden. Die Ventile 12, 13 können beispielsweise als Massflowcontroller ausgebildet sein. Die Massflowcontroller sind bevorzugt auf einen bestimmten, konstanten Medienfluss eingestellt.

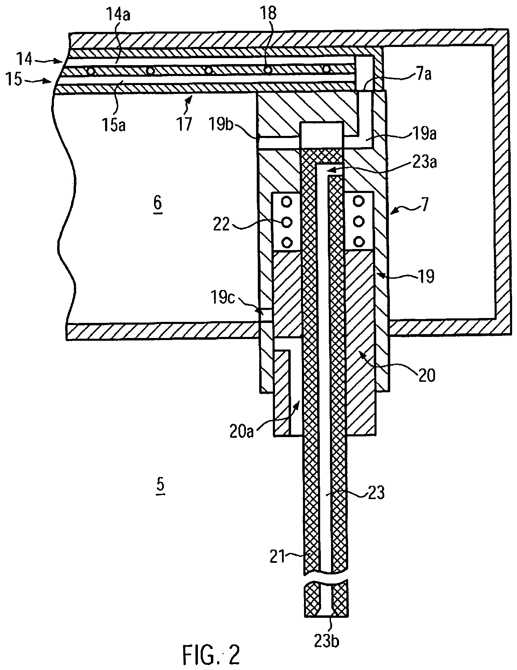

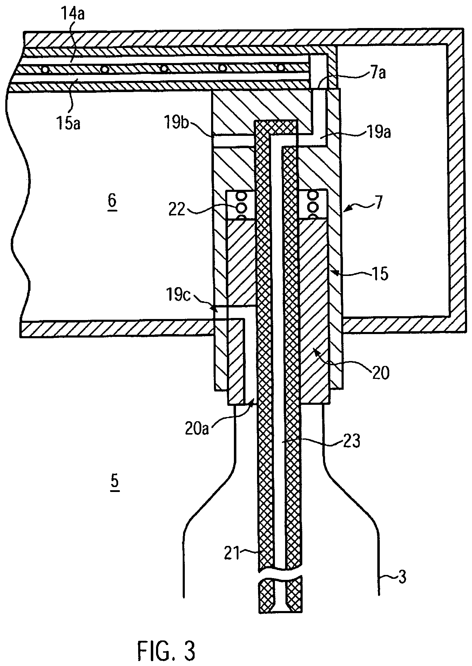

Jede der dritten, vierten Druckkammern 9a, 9b steht über eine Leitung 14 bzw. 15 mit allen Abnehmerstationen 2 in Verbindung. Die Leitungen 14, 15 münden in einen Anschluss 7a des Ventils 7 und weisen zwischen den Anschlüssen 7a und der jeweiligen Druckkammer 9a bzw. 9b kein weiteres Prozessmedienventil auf. Vor dem jeweiligen Anschluss 7a des Ventils 7 jeder Abnehmerstation 2 verläuft die Leitung 14, 15 über jeweils eine Kapillarstrecke (Fig. 2 und 3) 14a bzw. 15a. Die Kapillarstrecken 14a, 15a sind bevorzugt als Kapillarrohr aus einem geeigneten Kunststoff ausgebildet und können in den gewünschten Abmessungen problemlos hergestellt werden. Beide Kapillarstrecken 14a, 15a münden gemeinsam in den Anschluss 7a.

Die Kapillaren 14a, 15a sind Teil einer insgesamt mit 16 bezeichneten Einrichtung zum Konstanthalten vorbestimmter Strömungsverhältnisse, um eine vorbestimmte Durchflussmenge zu erreichen und konstant zu halten, die die im Stand der Technik notwendigen eigenen Prozessmedienventile an jeder Abnehmerstation ersetzt. Neben den einen definierten, möglichst kleinen Durchflussquerschnitt bereitstellenden Kapillarstrecken 14a, 15a, ist weiterhin eine Einrichtung zum Konstanthalten der Strömungsgeschwindigkeit durch die Kapillarstrecken 14a, 15a vorgesehen. Je nach den konstruktiven Gegebenheiten der Vorrichtung 1 kann die Einrichtung 16 beispielsweise Maßnahmen umfassen, um die Temperatur der Kapillarstrecken 14a, 15a im Wesentlichen konstant und ggf. auch auf einen von der Umgebungstemperatur abweichenden Wert zu halten. Im dargestellten Ausführungsbeispiel sind die Kapillarstrecken 14a, 15a in einem Wärmespeicher 17 untergebracht, der beispielsweise ein Aluminiumblock mit einer ausreichenden Wärmespeicherungsmasse sein kann. Zum Erhöhen der Temperatur kann der Wärmespeicher 17 eine Heizung 18 enthalten, z. B. ein Temperiergerät und Wasser als Wärmeträger. Obwohl in den Figuren nicht dargestellt, kann der Wärmespeicherblock 17 ringförmig ausgebildet sein und eine Mehrzahl, bevorzugt alle, Kapillarstrecken aller Abnehmerstationen 2 enthalten.

Die Einrichtung 16 sorgt weiterhin für einen definierten Druckabfall in den Leitungen 14, 15 zwischen dem jeweiligen Vorratsbehälter 10, 11 und, wie nachfolgend noch näher erläutert, der als Behandlungskammer ausgebildeten zweiten Druckkammer 6. Da die zweite Druckkammer 6 auf einen definierten Druck gebracht und gehalten wird, der beim Plasmabeschichten das Zünden eines Plasma gestattet, kann dies auch zur Konstanthaltung der Strömungsgeschwindigkeit innerhalb der Kapillarstrecken 14a, 15a ausgenutzt werden, indem der Massflowcontroller 12 bzw. 13 auf einen vorbestimmten, konstanten Durchfluss eingestellt wird. Dadurch baut sich in der jeweiligen dritten und vierten Druckkammer 9a, 9b ein gewisser Mediendruck auf, der im Gleichgewicht mit dem durch die Kapillarstrecken 14a, 14b entweichenden Medium und dem durch den Massflowcontroller 12 bzw. 13 zugeführten Medium steht. Auf diese Weise ist das System selbstregulierend und das in die dritte, vierte Druckkammer 9a, 9b eingeleitete Prozessmedium verteilt sich gleichmäßig auf alle Kapillarstrecken 14a, 15a aller angeschlossenen Abnehmerstationen 2. Die dritte und vierte Druckkammer 9a, 9b wirken somit als Puffer.

Auf diese Weise wird sichergestellt, dass zu allen Abnehmerstationen 2 die gleiche vorbestimmte Menge des Prozessmediums zugeführt wird.

Ein weiterer Vorteil der erfindungsgemäßen Verwendung der Kapillarstrecken 14a, 15a ergibt sich, wenn ein Prozessmedium eingesetzt wird, das zwar gasförmig benötigt wird, sich jedoch in flüssiger Form besser und einfacher handhaben und lagern lässt. Durch die erfindungsgemäße Einrichtung ist es möglich, dieses Prozessmedium zunächst flüssig durch die entsprechende Kapillare zu schicken, wobei es beim Austritt aus der Kapillare in das dort herrschende Vakuum (aus der als Behandlungskammer ausgebildeten zweiten Druckkammer 6) verdampft und somit im Behälter 3 in gasförmiger Form vorliegt.

Das Ventil 7 enthält einen im Wesentlichen zylindrischen Ventilkörper 19, in dem ein Stempel 20 axial verschiebbar ist. Im Stempel 20 ist ein Rohr 21 befestigt und mit ihm bewegbar, das z.B. als röhrenförmiger Mikrowellenleiter oder als röhrenförmige Elektrode ausgebildet sein kann. Zwischen dem Ventilkörper 19 und dem Stempel 20 ist eine Feder 22 vorgesehen, deren Vorspannung den Stempel 16 zum Verschließen der Behälteröffnung in Richtung auf den Behälter 3 drückt. Im Rohr 21 ist ein Einlasskanal 23 ausgebildet, der eine Einlassöffnung 23a, durch die das Prozessmedium aus den Kapillarstrecken 14a, 15a eintreten kann, und eine Auslassöffnung 23b aufweist, durch den das Prozessmedium in den Behälter 3 gelangt.

Im Ventilblock 19 ist ein Einlasskanal 19a ausgebildet, der mit dem Anschluss 7a in Verbindung steht und so angeordnet ist, dass er mit dem Einlass 23a des Kanals 23 fluchtend ausgerichtet ist, wenn sich der Stempel 20 in seiner obersten Stellung befindet.

Im Ventilkörper 19 ist weiterhin ein erster Auslasskanal 19b und ein zweiter Auslasskanal 19c vorgesehen, die beide in die Behandlungskammer 6 münden. Der erste Auslasskanal 19b ist fluchtend mit dem Einlasskanal 19a für eine Strömungsverbindung ausgebildet, wenn sich das Rohr 21 an der durch die Druckfeder 22 (und ggf. einem Anschlag) bestimmten untersten Stellung befindet. Der zweite Auslasskanal 19c ist mit einem Überströmkanal 20a ausrichtbar, der im Stempel 20 vorgesehen ist und in den Behälter 3 mündet. Ist der zweite Auslasskanal 19c mit dem Überströmkanal 20a verbunden, so findet ein Druckausgleich zwischen der Prozesskammern 6 und dem Behälter 3 statt.

Fig. 3 zeigt die Stellung des Ventils 7 bei Beginn eines Plasmabeschichtungsvorgangs. Wie gezeigt, wird der Behälter 3 gegen den Stempel 20 (beispielsweise durch eine Hubkurve) gedrückt, wobei die Behälteröffnung durch eine als Dichtfläche ausgebildete Unterseite des Stempels 20 abgedichtet wird. Der Hub wird so bemessen, dass der Stempel 20 unter Komprimierung der Feder 22 in den Ventilkörper 15 hineingedrückt wird, bis die als Prozesskammer ausgebildete zweite Druckkammer 6 und das Innere des Behälters 3 durch den Überströmkanal 20a miteinander verbunden sind. Durch den Unterdruck der zweiten Druckkammer 6 wird der Behälter 3 evakuiert. Gleichzeitig wird durch das Rohr 21 eine Strömungsverbindung zwischen dem Anschluss 7a über den Einlasskanal 19a in den Kanal 23 und von dort in den Behälter 3 geöffnet, durch die das zum Beschichten notwendige Prozessmedium bzw. die Prozessmedien in den Behälter 3 eingebracht werden. Dies geschieht über den Druckunterschied zwischen dem evakuierten Inneren des Behälters 3 und der dritten Druckkammer 9a bzw. der vierten Druckkammer 9b, deren Druck wiederum selbstregulierend über die Massflowcontroller 12 bzw. 13 und die Vorratsbehälter 10 bzw. 11 konstant gehalten wird. Während der Bewegung des Behälters 3 um die Achse 4' und über die Hubkurve um eine vorbestimmte Länge und mit vorbestimmter Geschwindigkeit gelangt somit eine vorbestimmte Prozessmediummenge in den Behälter 3, die zum Aufbau der gewünschten Beschichtung ausreicht.

Nach dem Ende des Beschichtungsvorgangs wird der Behälter 3, bevorzugt wiederum durch ein Absenken der Kurve, nach unten bewegt, wobei der Stempel 20 über den Druck der Feder 22, noch in dichtendem Abschluss mit der Behälteröffnung, folgt. Dadurch wird die Zufuhr über den Anschluss 7a getrennt und der Überströmkanal aus seiner Verbindung mit der als Prozesskammer ausgebildeten zweiten Druckkammer 6 gelöst, so dass der in der zweiten Druckkammer 6 herrschende Druck (Vakuum) über die Kanäle 19b und 19a wieder am Ende der Kapillarstrecken 14a, 15a anliegt und somit einen definierten Druckunterschied erzeugt. Diese Stellung ist in Fig. 2 dargestellt. Anschließend kann der Behälter 3 aus dem Rundläufer 4 entfernt werden.

Wird die erfindungsgemäße Vorrichtung 1 zum Versorgen von Abnehmerstationen auf einen Rundläufer für eine Plasmabeschichtung von Behältern (Innenseite) eingesetzt, so wird die als Prozesskammer ausgebildete zweite Druckkammer 6, die mit der Innenseite des Behälters 2 über die Kanäle 19c und 20a in Verbindung gebracht werden kann, auf einen Druck gebracht und gehalten, bei dem ein Plasma zünden kann, während die als Prozesskammer ausgebildete erste Druckkammer 5, die mit der Außenseite des Behälters 3 in Verbindung steht, auf einen Druck gebracht und gehalten werden kann, bei dem kein Plasma zünden kann. Im Verfahren soll im Inneren des Behälters unter einer Prozess-Gaslast von ca. 50sccm Prozessgas ein Druck von 0,1mbar herrschen. Als Prozessmedien wird Sauerstoff und Hexamethyldisiloxan (HMDSO) eingesetzt. Das HMDSO liegt in flüssiger Form vor, während Sauerstoff gasförmig angeliefert wird. Um einen Gasfluss von 50sccm Sauerstoff durch die entsprechende Kapillarstrecke zu erreichen, ist eine Druckdifferenz von ca. 600mbar notwendig. Die dritte/vierte Druckkammer mit dem jeweiligen Prozessmedium (Gas/Flüssigkeit) wird auf einen Druck von 600mbar gegenüber dem Ende der Kapillaren (7a), und damit gegenüber dem Druck in der als Prozesskammer ausgebildeten zweiten Druckkammer 6 stabilisiert, so dass aus dieser Kammer heraus mehrere Kapillaren parallel versorgt werden.

Die Kapillarstrecken für den gasförmigen Sauerstoff sind bevorzugt 600mm lang und weisen einen Innendurchmesser von 0,25mm auf. Die Kapillarstrecken für das flüssige HMDSO sind bevorzugt 1000mm lang und weisen einen Innendurchmesser von 0,10 mm auf. Die Temperatur der Kapillarstrecken wird durch Anschluss an den Wärmespeicher (Wärmebad) stabilisiert, wobei der Wärmespeicher mit der Heizeinrichtung (Temperiergerät und Wasser als Wärmeträger) auf 60°C erwärmt und stabilisiert wird. Die Massflowcontroller werden durch das entsprechende Medium unter einem Druck von üblicherweise 2bar gespeist. Dieses Vorgehen ist sowohl für flüssige als auch für gasförmige Prozessmedien gleich, mit dem Unterschied, dass das flüssige Prozessmedium beim Austritt in das Vakuum im Inneren des Behälters 3 verdampft und dann ebenfalls als Gas vorliegt.

In Abwandlung der beschriebenen und gezeichneten Ausführungsbeispiele kann die Erfindung auch bei anderen Vorrichtungen eingesetzt werden, bei denen einer Vielzahl von Abnehmern jeweils die gleichen, relativ geringen Mengen eines Prozessmediums zugeführt werden sollen. Auch die Konstruktion eines Rundläufers für eine Beschichtungsanlage ist nicht kritisch, so dass die Erfindung bei allen Beschichtungsanlagen eingesetzt werden kann.

## Patentansprüche

1. Beschichtungsvorrichtung (1) für Behälter (3), die zum Versorgen einer Vielzahl von Abnehmerstationen (2), die die Behälter (3) aufnehmen, mit einer vorbestimmten Menge eines Prozessmediums ausgebildet ist, wobei jede Abnehmerstation (2) ein Gasdruck-Ventil (7) umfasst,
ferner mit in Anschlüsse (7a) der Gasdruck-Ventile (7) mündenden Zufuhrleitungen (14) für das Prozessmedium, über die eine dritte Druckkammer (9a) mit allen Abnehmerstationen (2) in Verbindung steht,
**gekennzeichnet durch**
eine Einrichtung (16) zum Konstanthalten einer vorbestimmten Durchflussmenge und zur Erzeugung eines definierten Druckabfalls in den Zufuhrleitungen (14) zwischen einem Vorratsbehälter (10) für das Prozessmedium und einer als Behandlungskammer ausgebildeten zweiten Druckkammer (6), wobei die dritte Druckkammer (9a) dazwischen als Puffer wirkt und die Einrichtung (16) umfasst:
- der vorbestimmten Menge des Prozessmediums entsprechend bemessene Kapillarstrecken (14a), über die die Zufuhrleitungen (14) vor jedem Anschluss (7a) verlaufen; und
- eine den Anschlüssen (7a) gemeinsam zugeordnete Einrichtung zum Aufrechterhalten einer definierten Strömungsgeschwindigkeit über die Kapillarstrecken (14a), umfassend die dritte Druckkammer (9a) in Strömungsrichtung vor und die zweite Druckkammer (6) in Strömungsrichtung nach den Kapillarstrecken (14a).

2. Vorrichtung nach Anspruch 1, wobei die Kapillarstrecke (14a) ein Kunststoff-Kapillarrohr enthält.

3. Vorrichtung nach Anspruch 1 oder 2, wobei die Kapillarstrecke (14a) einen Innendurchmesser von 0,25 mm und eine Länge von 100 mm aufweist.

4. Vorrichtung nach einem der Ansprüche 1 bis 3, wobei die Kapillarstrecke (14a) in einem Wärmespeicher (17) untergebracht ist.

5. Vorrichtung nach Anspruch 4, wobei im Wärmespeicher (17) eine Vielzahl Kapillarstrecken (14a, 15a) untergebracht sind.

6. Vorrichtung nach einem der Ansprüche 1 bis 5, wobei die Kapillarstrecke (14a) eine Heizeinrichtung (18) enthält.

7. Vorrichtung nach einem der Ansprüche 1 bis 6, wobei die Einrichtung zum Aufrechterhalten einer definierten Strömungsgeschwindigkeit selbstregulierend ausgebildet ist.

8. Vorrichtung nach einem der Ansprüche 1 bis 7, wobei die Abnehmerstationen (2) auf einem Rundläufer (4) angeordnet und an einen Prozessmedienspeicher (10) angeschlossen sind.

9. Vorrichtung nach einem der Ansprüche 1 bis 8, wobei zur Versorgung der Abnehmerstationen (2) mit einer Mehrzahl von Prozessmedien, für jedes Prozessmedium eine Einrichtung (16) zum Konstanthalten vorbestimmter Strömungsverhältnisse, die eine der vorbestimmten Menge des Prozessmediums entsprechend bemessene Kapillarstrecke (14a, 15a) vor jedem Anschluss (7a) und für jedes Prozessmedium eine einer Mehrzahl von Anschlüssen (7a) zugeordnete Einrichtung zum Aufrechterhalten einer definierten Strömungsgeschwindigkeit über die Kapillarstrecke (14a, 15a) vorgesehen ist.

10. Vorrichtung nach einem der Ansprüche 1 bis 9, wobei zur Versorgung der Abnehmerstationen (2) mit einem gasförmigen Prozessmedium, die Einrichtung (16) zum Konstanthalten vorbestimmter Strömungsverhältnisse auf das Prozessmedium in flüssigem Zustand ausgelegt und so ausgebildet ist, dass das flüssig durch die Kapillarstrecke (15a) hindurchtretende Prozessmedium beim Austritt aus der Kapillarstrecke (15a) verdampfbar ist.

## Claims

1. Coating device (1) for containers (3), for supplying a large number of consumer stations (2) accommodating the containers (3), with a predetermined amount of a process medium, wherein each consumer station (2) comprises a gas pressure valve (7),
further comprising supply lines (14) for the process medium, terminating in connections (7a) of the a gas pressure valves (7) and providing a connection between a third pressure chamber (9a) and all consumer stations (2),
**characterized by**
a unit (16) for keeping a predetermined flow rate constant and for providing a defined pressure drop in the supply lines (14) between a reservoir (10) for the process medium and a the second pressure chamber (6) configured as a treatment chamber, wherein the third pressure chamber (9a) acts as a buffer therein between and said unit (16) comprises:
- capillary paths (14a) dimensioned in accordance with the predetermined amount of the process medium, via which the supply lines (14) extend before each connection (7a); and
- a unit which is associated with the plurality of connections (7a) in common and which is configured for maintaining a defined flow velocity along the capillary paths (14a), comprising the third pressure chamber (9a) upstream of the capillary paths (14a) and the second pressure chamber (6) downstream of the capillary paths (14a).

2. Device according to claim 1, wherein the capillary path (14a) comprises a capillary tube made of plastic material.

3. Device according to claim 1 or 2, wherein the capillary path (14a) has an inner diameter of 0.25 mm and a length of 100 mm.

4. Device according to one of the claims 1 to 3, wherein the capillary path (14a) is accommodated in a heat store (17).

5. Device according to claim 4, wherein a large number of capillary paths (14a, 15a) is accommodated in the heat store (17).

6. Device according to one of the claims 1 to 5, wherein the capillary path (14a) includes a heating means (18).

7. Device according to one of the claims 1 to 6, wherein the unit for maintaining a defined flow velocity is implemented as a self-regulating unit.

8. Device according to one of the claims 1 to 7, wherein the consumer station (2) is arranged on a carousel (4) and connected to a process media reservoir (10).

9. Device according to one of the claims 1 to 8, wherein, for supplying the consumer stations (2) with a plurality of process media, a unit (16) for maintaining predetermined flow conditions is provided for each process medium, said unit (16) comprising a capillary path (14a, 15a) extending before each connection (7a) and dimensioned in accordance with the predetermined amount of process medium, and further comprising, for each process medium, a unit which is associated with a plurality of connections (7a) and which is used for maintaining a defined flow velocity along the capillary path (14a, 15a).

10. Device according to one of the claims 1 to 9, wherein, for supplying the consumer station (2) with a gaseous process medium, the unit (16), which is used for keeping predetermined flow conditions constant, is adapted to the process medium in a liquid state and is implemented such that the process medium flowing through the capillary path (15a) in a liquid state is evaporable upon discharge from said capillary path (15a).

## Revendications

1. Appareil de revêtement (1) pour conteneurs (3), qui est conçu pour alimenter une pluralité de postes de consommation (2), qui reçoivent les conteneurs (3), avec une quantité prédéterminée d'un milieu de traitement, dans lequel chaque poste de consommation (2) comporte une soupape de pression de gaz (7),
ayant en outre des conduites d'alimentation (14) pour le milieu de traitement qui débouchent dans des raccords (7a) des soupapes de pression de gaz (7), et via lesquelles une troisième chambre de pression (9a) est en communication avec tous les postes de consommation (2),
**caractérisé par**
un dispositif (16) destiné à maintenir constant un débit prédéterminé et à générer une chute de pression définie dans les conduites d'alimentation (14) entre un conteneur d'alimentation (10) pour le milieu de traitement et une deuxième chambre de pression (6) conçue sous la forme d'une chambre de traitement, dans lequel la troisième chambre de pression (9a) agit en tant que tampon entre les deux, et le dispositif (16) comprend :
- des voies capillaires (14a) dimensionnées pour correspondre à la quantité prédéterminée du milieu de traitement, sur lesquelles les conduites d'alimentation (14) s'étendent avant chaque raccord (7a) ; et
- un dispositif associé en commun aux raccords (7a) pour maintenir une vitesse d'écoulement définie sur les voies capillaires (14a), comprenant la troisième chambre de pression (9a) en amont dans la direction de l'écoulement et la deuxième chambre de pression (6) en aval dans la direction d'écoulement par rapport aux trajets capillaires (14a).

2. Appareil selon la revendication 1, dans lequel la voie capillaire (14a) contient un tube capillaire en plastique.

3. Appareil selon la revendication 1 ou 2, dans lequel la voie capillaire (14a) a un diamètre interne de 0,25 mm et une longueur de 100 mm.

4. Appareil selon l'une des revendications 1 à 3, dans lequel la voie capillaire (14a) est logée dans un accumulateur de chaleur (17).

5. Appareil selon la revendication 4, dans lequel une pluralité de voies capillaires (14a, 15a) sont logées dans l'accumulateur de chaleur (17).

6. Appareil selon l'une des revendications 1 à 5, dans lequel la voie capillaire (14a) contient un dispositif de chauffage (18).

7. Appareil selon l'une quelconque des revendications 1 à 6, dans lequel le dispositif pour maintenir une vitesse d'écoulement définie est conçu auto-régulé.

8. Appareil selon l'une des revendications 1 à 7, dans lequel les postes de consommation (2) sont agencés un plateau tournant (4) et connectés à un support de milieux de traitement (10).

9. Appareil selon l'une des revendications 1 à 8, dans lequel pour alimenter les postes de consommation (2) avec une pluralité de milieu de traitement, pour chaque milieu de traitement, un dispositif (16) destiné à maintenir constantes des conditions d'écoulement prédéterminées est prévu, les voies capillaires (14a, 15a) dimensionnées pour correspondre à la quantité prédéterminée du milieu de traitement, avant chaque raccord (7a), et pour chaque milieu de traitement (7a), un dispositif associé à une multiplicité de raccord (7a) est prévu, pour maintenir une vitesse découlement définie sur les voies capillaires (14a, 15a).

10. Appareil selon l'une des revendications 1 à 9, dans lequel pour alimenter les postes de consommation (2) avec un milieu de traitement gazeux, le dispositif (16) pour maintenir des conditions d'écoulement prédéterminées sur le milieu de traitement à l'état liquide est conçu et réalisé pour que le milieu de traitement passant de manière fluide par la voie capillaire (15a) puisse être vaporisé à la sortie de la voie capillaire (15a) .
